# EUROPEAN PATENT APPLICATION

(11) **EP 4 810 938 A1**
(43) Date of publication of application: **23.09.2026**
(21) Application number: 26160712.1
(22) Date of filing: 25.02.2026
(51) Int. Cl.: G01N 15/0205, G01N 15/10, G01N 15/1429, G01N 21/47

(54) **FABRICATION OF MICROTARGETS FOR TESTING AN OPTICAL PARTICULATE SENSOR (OPS)**

(30) Priority: 20.03.2025 US 202519085935
(71) Applicant: Honeywell International Inc., Charlotte, NC 28202 (US)
(72) Inventor: GAO, Kaizhong, Charlotte, 28202 (US); BADIN, Pavel, Charlotte, 28202 (US); DRAZAN, Viktor, Charlotte, 28202 (US)
(74) Representative: Haseltine Lake Kempner LLP

(57) **Abstract**

A method for fabricating microtargets for sensor calibration and testing is provided. The method includes: determining size, shape, curvature and locations for the microtargets; forming a layer of photoresist on a surface of a wafer; forming a mask having a plurality of openings with size, shape, and locations corresponding to the microtargets; heating the wafer and the layer of photoresist; exposing the layer of photoresist through the mask; removing photoresist in the layer of photoresist that was exposed outside the locations of the microtargets; and heating the wafer with a temperature and duration to solidify the microtargets.

## Description

### BACKGROUND

Optical particulate sensors are implemented in many types of systems, such as aircraft, for Atmospheric condition sensing. Such sensors can be implemented as a lidar system that uses optical signals to analyze characteristics of small and large particulate matter in the surrounding environment of, for example, the aircraft (aerosol particles, such as water droplets, ice crystals, volcanic ash, sand and dust particles). Optical particulate sensors are regularly calibrated and tested to ensure consistent functionality and optimal performance.

Existing systems and methods for testing and calibrating such optical particulate sensors are large, heavy, and complex. Further, such systems are typically limited to use in a laboratory environment due to the use of a distilled water supply that generates test droplets or pressurized air that is used for aerosolization of solid particle size standards. Further, such equipment requires regular maintenance and cleaning to function properly.

Therefore, a need exists to reduce the size, weight, and complexity of systems used to test optical particulate sensors.

### SUMMARY

A method for fabricating microtargets for sensor calibration and testing is provided. The method includes: determining size, shape, curvature and locations for the microtargets; forming a layer of photoresist on a surface of a wafer; forming a mask having a plurality of openings with size, shape, and locations corresponding to the microtargets; heating the wafer and the layer of photoresist; exposing the layer of photoresist through the mask; removing photoresist in the layer of photoresist that was exposed outside the locations of the microtargets; and heating the wafer with a temperature and duration to solidify the microtargets

### BRIEF DESCRIPTION OF THE DRAWINGS

Embodiments of the present invention can be more easily understood and further advantages and uses thereof more readily apparent, when considered in view of the description of the preferred embodiments and the following figures in which:
FIG. 1 depicts a block diagram of one embodiment of a system for testing an optical particulate sensor (OPS) with microtargets formed on an oscillating carrier.
FIG. 2 is a block diagram of another embodiment of a system for testing and calibrating an optical particle sensor with microtargets on a rotating wafer or disk.
FIG. 3 is a graph that illustrates an exemplary relationship between linear velocity and a radius of the rotating wafer or disk of FIG. 2.
FIG. 4 is a flow chart illustrating one embodiment of a process for fabricating microtargets according to the teachings of the present invention.
FIGs. 5A to 5C are cross sectional views that illustrate one embodiment of a process for fabricating microtargets for testing and calibration of an OPS.
FIG. 6 illustrates perspective views of various shapes for microtargets according to the teachings of the present invention.
FIGs. 7A and 7B are front and side views, respectively, of one embodiment of a disk with microtargets formed thereon for testing an OPS by rotating the carrier.
FIGs. 8A and 8B are front and side views, respectively, of one embodiment of a carrier with microtargets formed thereon for testing an OPS by oscillating the carrier.
FIG. 9 is a flow chart illustrating another embodiment of a process for fabricating microtargets according to the teachings of the present invention.

In accordance with common practice, the various described features are not drawn to scale but are drawn to emphasize features relevant to the present invention. Reference characters denote like elements throughout figures and text.

### DETAILED DESCRIPTION

In the following detailed description, reference is made to the accompanying drawings that form a part hereof, and in which is shown by way of specific illustrative embodiments in which the invention may be practiced. These embodiments are described in sufficient detail to enable those skilled in the art to practice the invention, and it is to be understood that other embodiments may be utilized and that logical, mechanical and electrical changes may be made without departing from the scope of the present invention. The following detailed description is, therefore, not to be taken in a limiting sense.

Embodiments of the present invention replace conventional water microdroplets or particulate standards and their associated apparatus with a dedicated calibration device where solid microtarget are positioned on a carrier or are integrated within the carrier to test and/or calibrate an optical particulate sensor. Various embodiments of microtargets, and techniques for fabricating the microtargets, that can be used for testing and calibrating an Optical Particulate Sensor (OPS) are described in detail below. In general, these microtargets replace the water microdroplets or particulate standards with solid microlines or dots. In one embodiment, the microtargets have sizes from units of micrometers to hundreds of micrometers (microns) fabricated using processes described in more detail below.

The microtargets used in embodiments of the present invention are formed from any appropriate material to produce a line, dot, 2D or 3D particle structure of an appropriate size and reflectivity. The microtargets are designed to simulate potential particles to be sensed by an OPS under test. So, the dots and lines are sized similar to those potential particles. Additionally, the particles reflect/scatter light from the OPS, so the material, such as metals, epoxy, photoresist, polymer or metallic oxide, from which the microtargets are formed, also similarly reflects/scatters light from the OPS. This enables the OPS to receive the light reflected/scattered by the microtargets so that a detector of the OPS can produce an output that correlates to a characteristic (e.g., size) of particles to be sensed by the OPS under test.

### Oscillating Carrier

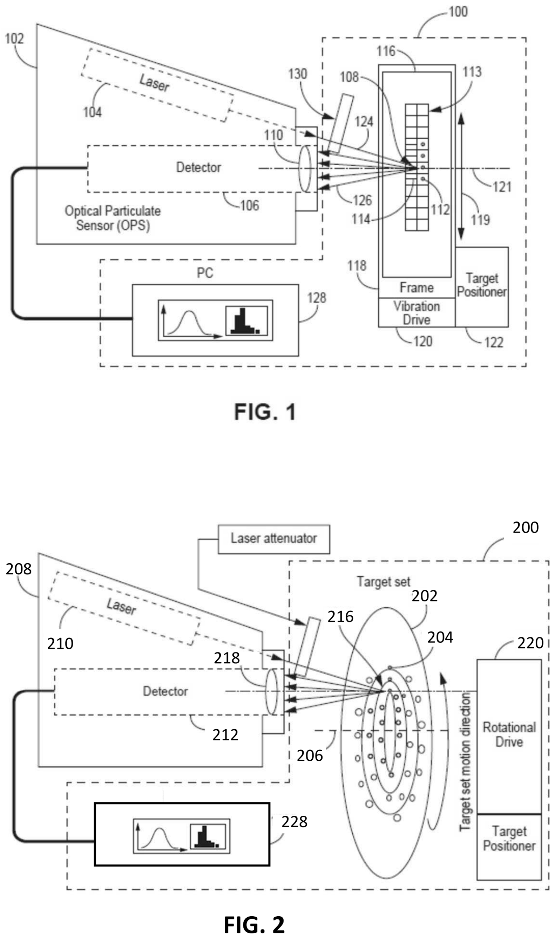

FIG. 1 is a block diagram of one embodiment of a system 100 for testing and calibrating an optical particulate sensor (OPS) 102. OPS 102 includes laser 104 and detector 106. Laser 104 of OPS 102 irradiates measurement volume 108 with light. Particles in measurement volume 108 cause the light from laser 104 to reflect/scatter back toward OPS 102. This reflected/scattered light passes through lens 110 into detector 106 which includes a photodetector that measures the amount of light reflected by any particles present in measurement volume 108. Detector 106 produces an output signal, based on the response of the photodetector which is provided to system 100.

Instead of creating and injecting particles into the measurement volume 108 of OPS 102, system 100 places microtargets 113 in measurement volume 108 of OPS 102 to simulate the presences of particles moving through measurement volume 108. In one embodiment, microtargets 113 comprise, for example, dots 112 and/or lines 114 on carrier 116. Embodiments for fabricating microtargets 113 (e.g., dots 112) on carrier 116 are described in more detail below.

Carrier 116 is mounted on frame 118 so that a selected one of the microtargets 113 (dots 112 and lines 114) is positioned in measurement volume 108. Each microtarget 113 on carrier 116 is available to be used to test OPS 102. During testing, the selected microtarget 113 is moved up and down (see arrow 119) through measurement volume 108 by vibration drive 120 to simulate the motion of particles in measurement volume 108. To simulate the motion of a particle, the selected microtarget 113 leaves measurement volume 108 on each end of the vibration before the direction of its motion changes at the maximum shift (amplitude) of vibration. In one embodiment, the photodetector of detector 106 cannot detect the direction of flight of the microtarget 113 (or particle in normal operation). Therefore, vibrating the microtarget during a test in the same orientation of expected motion of a particle during normal operation will produce the same net result on the output of detector 106. That is, the number of microtargets 113 detected by OPS 102 is double the vibration frequency of vibration drive 120 (e.g., 100 "particles" detected for a 50 Hz vibration frequency of vibration drive 120). Additionally, system 100 also includes target positioner 122 which is used to adjust the location of carrier 116 and its microtargets 113 (dots 112 and/or lines 114), in measurement volume 108 of OPS 102 and to select the microtarget 113 which will be used for test if several microtargets 113 are available on carrier 116.

In some embodiments, system 100 includes light conditioning subsystem 130 that conditions or modifies incident light 124 from laser 104. In one embodiment, light conditioning subsystem 130 is an attenuator that attenuates light from laser 104 to prevent the photodetector of detector 106 from being overloaded. In other embodiments, light conditioning subsystem 130 provides a half-wave plate which is configured to rotate the polarization of the light from laser 104 by 90 degrees so that sensors that use polarized light can be tested by system 100. In other embodiments, light conditioning subsystem 130 modifies any appropriate characteristic of the light from laser 104 to enable system 100 to test/calibrate all sensor channels.

In one embodiment, system 100 is implemented in a simple, robust and compact test/calibration device with low power requirements. In other embodiments, system 100 is a tabletop test/calibration device that is attachable to OPS 102 and used in production or in the shop before sensor installation into, for example, an aircraft. Further, in other embodiments, system 100 is a portable battery powered device that is configured to be attached to, for example, a sensor window on an aircraft surface and used to test OPS 102 without dismounting from the aircraft. When used to test a sensor installed in an aircraft, the sensor under test might be covered by an additional window protecting the sensor and assuring aircraft body aerodynamics and transparency of the additional window will be tested as well.

In operation, a particular size of particle is simulated in measurement volume 108 by using target positioner 122 to position the appropriate microtarget 113 (dots 112 or lines 114) on carrier 116 in a location such that vibration drive 120 can cause the dot 112 or line 114 to move up and down through the entire measurement volume 108 to simulate the motion of a particle. Laser 104 of OPS 102 transmits incident light 124 at measurement volume 108. When the selected dot 112 or line 114 pass through the incident light, reflected/scattered light 126 passes through lens 110 into detector 106 and data is sent to processing system 128. It is expected OPS 102 could communicate with processing system 128 of system 100, either by wireless communication or by dedicated wired connection, allowing automatic sensor calibration.

Processing system 128 processes digitized flashes of light 126 from the output of detector 106 and calculates a characteristic of the microtargets, e.g., width or size. By comparing the calculated characteristic with the known characteristic of the microtarget, calibration coefficients could be calculated and, with correction based on material differences (microtarget versus anticipated particles) could be used in OPS 102 during normal operation to ensure optimal performance and consistent functionality of OPS 102.

### Rotating Carrier

The embodiments of the system for testing and calibrating an OPS described above use a vibration drive to move the carrier up and down through a measurement volume in a linear manner through a measurement volume. In such embodiments, due to the finite sample size, the oscillation frequency and amplitude are limited. Typically, the linear velocity can reach about 10 meters per second (m/s). When the oscillation reaches the largest displacement position, the linear velocity reduces to zero and the calibration target is out of sensor sampling volume. The calibration is conducted when the linear velocity reaches its maximum, the sampling time is therefore relatively limited. The disadvantage of such a solution are vibrations caused by the fast oscillation movement. Additionally, integrating multiple calibration targets onto the oscillating platform would result in a large calibration tool and increased manufacturing costs.

FIG. 2 is a block diagram of one embodiment of a system 200 for testing and calibrating an OPS 208 that enables simulation of particles that travel at speeds in excess of 30 m/s. In this embodiment, system 200 includes a carrier 202 that has a plurality of microtargets 204 formed thereon. System 200 includes a rotational drive 220 that causes carrier 202 to rotate such that plurality of microtargets 204 spin around a central axis 206 of carrier 202. The plurality of microtargets 204 on carrier 202 have a selected particle size to be measured. Since the particle size is known and can be accurately controlled (as described in more detail below) and the speed of the disk is also known, the linear velocity of the plurality of microtargets 204 can be also accurately controlled. Advantageously, system 200 provides a valid solution to enable fast and accurate measurement of particles moving at speeds in excess of 30 m/s, introducing almost zero vibrations and allowing plurality of calibration microtargets to be integrated onto a compact carrier.

As with the embodiments described above, system 200 is designed to test and calibrate OPS 208. OPS 208 includes laser 210 ("transmitting optics") and detector 212 ("receiving optics"). Laser 210 of OPS 208 irradiates measurement volume 216 with light. Particles in measurement volume 216 cause the light from laser 210 to reflect/scatter back toward OPS 208. This reflected/scattered light passes through lens 218 into detector 212 which includes a photodetector that measures the amount of light reflected by any particles present in measurement volume 216. Detector 212 produces an output signal, based on the response of the photodetector which is provided to system 200 at PC 228 to determine particle size and composition based on this reflected light. Different types of materials may have different reflection amplitudes for the same particle size. To achieve high throughput and accurate measurements suitable for manufacturing and field testing, system 200 rotates plurality of microtargets 204 through measurement volume 216 at sufficient speeds to simulate real-world conditions.

In one embodiment, carrier 202 (wafer or disk) is mounted on a spindle motor (rotational drive 220) and rotated at high speed that can vary between 3,600 to 15,000 rotations per minute (RPM), which can easily create a consistent linear velocity exceeding 30 m/s. It is noted that the speed at which a set of microtargets 204 moves will depend on how far the set of microtargets is located from the center of the disk or wafer of carrier 202. For example, system 200 causes microtargets 204 to move with a selected speed through the measurement volume 216 by selectively aligning microtargets that are disposed on carrier 202 at the correct distance from the center of the wafer or disk.

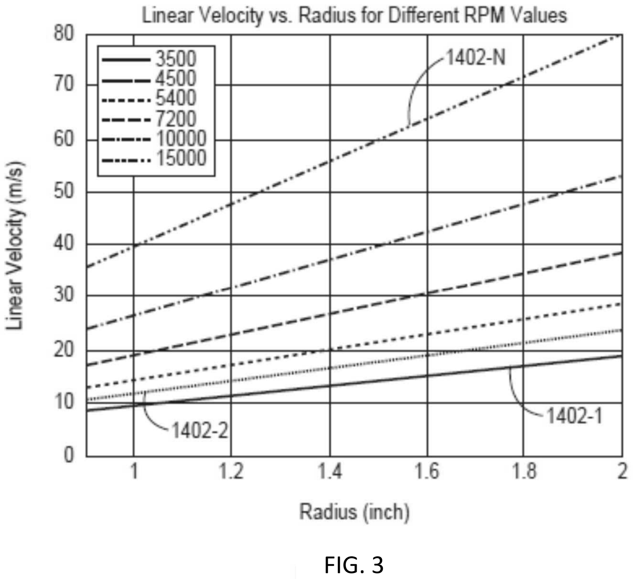

FIG. 3 is a graph that illustrates an exemplary relationship between linear velocity of microtargets 204 and a radius of the rotating wafer or disk (carrier 202) of FIG. 2. The radius at which the microtargets are formed is plotted along the X-axis while the linear velocity is plotted along the Y-axis. The various lines 302-1 to 302-N reflect spinning wafer or disk (carrier 202) at different numbers of rotations per minute (from 3,600 to 15,000 RPM). The results show that by simply increasing the distance from the center of the disk and the disk rotation speed, one can conduct measurements with a sample velocity between 10 and 80 m/s.

In one embodiment, rotational drive 220 includes a spindle motor that has low power consumption and can be driven to enable RPM at the values shown in FIG. 3. The characterization is conducted without OPS 208 touching the rotating samples; thus, a reliable source of preset particle size can be utilized to enable accurate measurement.

### Fabrication of Microtargets

Embodiments of the present invention use a semiconductor process to fabricate microtargets for testing and calibration of an optical particulate sensor (OPS) with a well-controlled size and shape. For example, in one embodiment, microtargets of different sizes with a rounded shape are formed on the surface of a substrate, e.g., a wafer such as a circular wafer. In one embodiment, the photolithography method is used to create a three-dimensional, round particle structure with accurate control of the particle dimension and shape, e.g., a diameter between 1 micrometer and 200 micrometers. However, instead of defining critical dimensions on metal film or an oxidate layer, embodiments of the present invention use photolithography methods on a photoresist to achieve the desired results, rather than metal materials.

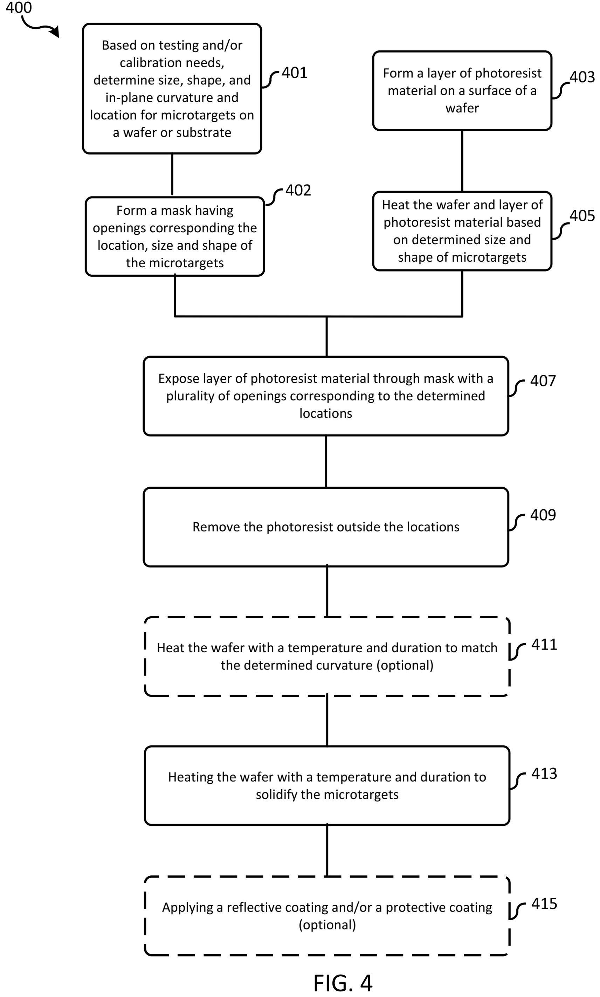

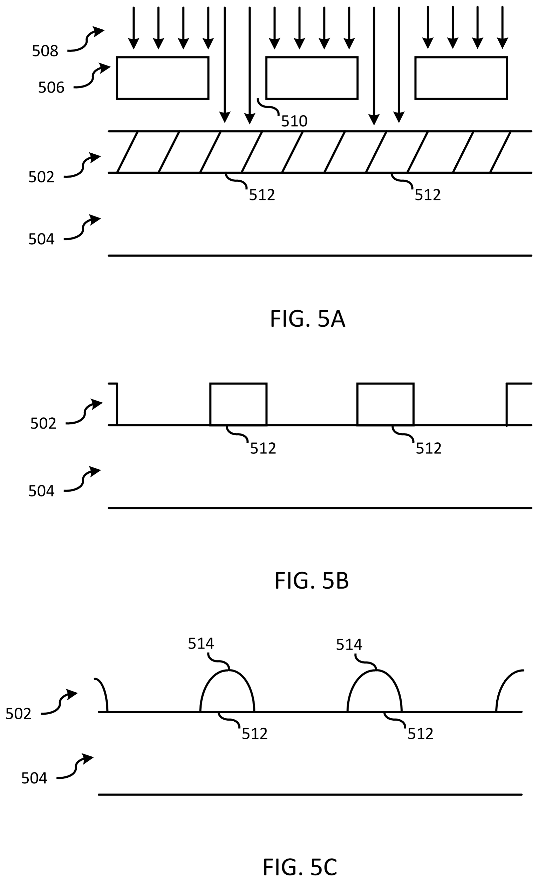

FIG. 4 is a flow chart illustrating one embodiment of a process 400 for fabricating microtargets using photoresist according to the teachings of the present invention. For pedagogical purposes, process 400 is described with reference to cross-sectional views in FIGs. 5A to 5C of a carrier with microtargets formed thereon from photoresist material at various points during the fabrication process. It is noted that the blocks illustrated in the flow chart are exemplary and not intended to limit the order or sequence in which they are performed. The blocks may be rearranged or performed in different sequences, including performing various blocks in parallel, without departing from the scope of the invention.

At block 401, process 400 determines the size, shape, in-plane curvature, and location of microtargets on wafer or substrate 504 based on the testing and/or calibration to be performed for an OPS, such as OPS 102 of FIG. 1 or OPS 208 of FIG. 2. For example, the size and shape of microtargets may be selected based on the range of sizes and shapes of particles expected to be encountered by the OPS. Further, the location of the microtargets can be determined based on the anticipated speed of particles expected for the OPS. The location of the microtargets may also be chosen to fully test the measurement volume of the OPS. Block 401 results in a template for the layout of the microtargets on wafer or substrate 504. At block 402, this template is used to create a mask with openings corresponding to the location, size, and shape of the microtargets.

At block 403, a layer of photoresist material 502 is applied to a wafer or substrate 504. In one embodiment, the photoresist is applied using a spin coating technique. This process involves depositing a small amount of photoresist onto the center of the wafer and then spinning the wafer to spread the photoresist by centrifugal force. In some embodiments, layer of photoresist 502 is evenly distributed over the surface of wafer or substrate 504. In other embodiments layer of photoresist 502 is selectively applied to be thicker in some regions on wafer or substrate 504 so that microtargets of different heights can be fabricated. Advantageously, this enables the microtargets to test the entire measurement volume of the OPS under test.

At block 405, a soft bake is applied to wafer or substrate 504 and layer of photoresist material 502 to remove the solvent from the photoresist, leaving behind a more solid film.

It is noted that actions identified in block 403 and block 405 may be performed before, during or after the actions identified in block 401 and block 402.

At block 407, process 400 uses photolithography to define the location of the microtargets. In this photolithography process, the layer of photoresist material 502 is exposed to light with a wavelength selected to develop the photoresist, e.g., ultraviolet (UV) light 508 through a mask 506. The mask 506 is designed and created to have a pattern of openings that corresponds precisely to the locations 512 and having the size and shape of the microtargets determined at block 401. For example, a round opening or window 510 in the mask 506 of appropriate size and position is placed over the locations 512 of each microtarget, e.g., round openings in the mask for each round microtarget. The mask 506 defines the areas where the layer of photoresist material 502 remains after development. It is understood that each opening or window 510 is formed to meet the specifications for that location. Openings or windows 510 of varying size and shape are contemplated depending on what is needed to test or calibrate a particular ) OPS. Regarding shape, the opening or window 510 may be round, oval, square, triangle or any other appropriate shape.

At block 409, process 400 develops the layer of photoresist material 502. Once developed, the photoresist material remains in locations 512 on wafer or substrate 504 for each microtarget and is removed from the rest of the wafer or substrate 504. In this embodiment, a negative photoresist is used. With a negative photoresist, the portion of the photoresist that is exposed to light becomes insoluble in the photoresist developer and the unexposed portion of the photoresist is dissolved by the photoresist developer. Here, mask 506 shields the portion of the layer of photoresist that corresponds to the locations of the microtargets (See FIG. 5A) so that the exposed portions (outside the areas of the microtargets) are removed by development of the negative photoresist at block 409 (See FIG. 5B).

In an alternative embodiment, the photoresist is a positive photoresist. A positive photoresist is a type of photoresist in which a portion is exposed to light and becomes soluble to the photoresist developer. The unexposed portion of the photoresist remains insoluble in the photoresist developer. Thus, when developed, the positive photoresist remains where it was not exposed to light at block 409. Thus, the mask in this embodiment would have openings where the microtargets are not be formed on wafer or substrate 504.

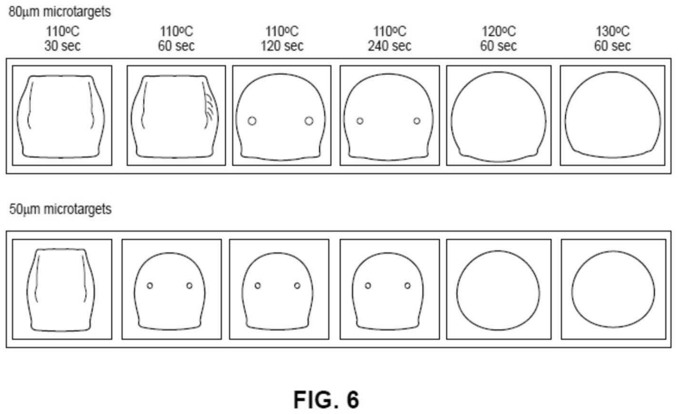

At block 411, process 400 optionally performs a thermal reflow of the remaining portions (microtargets) of layer of photoresist material 502. During the thermal reflow, the remaining portions of the layer of photoresist material 502 are heated, along with the wafer or substrate 504, to a temperature above the glass transition temperature of the layer of photoresist material 502, causing the photoresist to reflow and form a more rounded shape due to surface tension. By selectively changing the detailed process specifications applied to the wafer or substrate 504 at block 411, such as the thermal reflow temperature, and/or applying additional (UV) light or other conditions, the shape of the microtargets may be modified in the third dimension, e.g., height relative to the surface of the wafer or substrate. The in-plane shape (circle, oval, square, triangle, etc.) of the microtargets on the wafer or substrate 504 is defined precisely and well-controlled when creating the opening in mask, although the initial shape and size of the microtarget established by the mask is not the final shape and size of the microtarget. The final shape and size are ultimately controlled by the thermal reflow process, when used, but the feature size in the mask is established based on the known changes that will occur in thermal reflow so as to achieved the planned size and shape of the microtarget. The exact temperature and time are determined based on the specific photoresist and feature size. Thus, the remaining portions of layer of photoresist material 502 have become microtargets 514. By way of example, FIG. 6 illustrates perspective views of a number of microtarget structures formed from AZ 40XT photoresist with various shapes after performing the reflow process at block 411. In these examples, microtargets of 80 and 50 micrometers are illustrated after thermal reflow at specified temperatures and durations.

At block 413, process 400 includes a hard bake of the wafer or substrate 504 and remaining portions of the layer of photoresist material 502 (microtargets 514). The hard bake solidifies the remaining portions of the layer of photoresist material 502 to produce the microtargets 514. Application of process 400 produces microtargets 514 in the determined locations 512 such that the microtargets 514 also have the determined size, shape and curvature.

FIGs. 17A, 17B and 18 of co-pending US Patent Application Serial Number 19/081,539 filed on March 17, 2025 (the '539 Application) illustrate disk-shaped carriers with micortargets formed thereon. These carriers include a plurality of pie-shaped sections that have different heights, e.g, the surfaces of the pie shaped sections are located at different distances from the OPS under test. The process of FIG. 4 may be used to produce microtargets for such carriers. Using process 400, microtargets are formed on a circular wafer or substrate in concentric tracks on the surface of the wafer or substrate. The wafer or substrate with the microtargets formed therein is then cut into pie-shaped sections and those section are mounted on an appropriate structure with the selected heights such as shown in FIGs. 17A, 17B and 18 of the '539 Application.

At block 415, process 400 includes an option to add either a reflective coating or a protective coating to the microtargets 514. When a reflective coating is applied to microtargets 514, it increases the reflectivity of the microtargets and thus improves the signal level received by the OPS under test. To apply a reflective coating, process 400 may use the same mask used to define the microtargets 514 at block 407 to enable a reflective material to be applied to the microtargets 514 by a sputtering process. It is noted that the reflective coating could be applied to a subset of microtargets 514 so that a portion of the microtargets have increased reflectivity. In this embodiment, a mask is created that only exposes the microtargets in a portion of the wafer to receive the reflective coating. When a protective coating is desired, process 400 forms the protective coating layer on (1) the surface of the wafer or substrate, (2) the microtargets or (3) both the surface of the wafer and the microtargets to prevent water or dust from accumulating or sticking to the wafer and/or microtargets. In one embodiment, the protective coating layer is formed from a hydrophobic material that resists water, e.g., hydrophobic polymers.

It is noted that, in process 400, application of the photoresist layer at block 403 and the photolithography at block 407 provide accurate control of the size of microtargets 514 (diameter and volume). Further, by tuning the process conditions utilized in blocks 409, 411 and 413, the desired shape of each microtarget 514 can be achieved such as illustrated in FIG. 6.

A typical photoresist consists of three main components:
Resin: Provides physical properties such as adhesion and chemical resistance.
Sensitizer: Contains a photoactive compound that changes solubility when exposed to light.
Solvent: Keeps the resist in liquid form for application onto the wafer.

For the specific application, a photoresist that has the appropriate properties for the feature size and the substrate used for creating microtargets for testing and calibration of an OPS is selected. For example, for features in the micrometer range, a photoresist like SU-8, which is a commonly used negative photoresist capable of creating high aspect ratio structures and is suitable for both silicon and glass substrates may be used.

The rotating disk method mentioned is part of the spin coating process, which is standard for applying photoresist evenly across the wafer surface. The rotating disk method works well for the creation of microtargets, provided the other conditions (such as viscosity of the photoresist and spin speed) are optimized for the desired thickness and feature size. Advantageously, forming microtargets on a circular disk enables use of a rotating carrier which exceeds the limitations of the oscillation method and achieves a consistent linear velocity exceeding 50 m/s, more closely mimicking the conditions for an OPS used on an aircraft.

As described above, process 400 of FIG. 4 can be used to create microtargets with round shapes using photoresist in a rapid and cost-effective approach for production-scale operations. Further, process 400 can be controlled with a high degree of accuracy when the following factors are considered:
Spin Coating: The thickness of the photoresist can be precisely controlled by adjusting the spin speed and time during the spin coating process at block 403 of FIG. 4. Higher spin speeds result in thinner films, while lower speeds result in thicker films.

Mask Design: The dimensions or diameter of the features can be accurately defined by the mask used during photolithography at block 407. The mask will have the exact pattern that is transferred onto wafer or substrate 504.

Exposure and Development: The exposure time and the development process at blocks 407 and 409 will also affect the final feature size. These parameters can be finely tuned to achieve the desired dimensions.

Thermal Reflow: After the development process, the wafer is heated to a temperature above the glass transition temperature of the photoresist at block 411. This causes the photoresist to reflow and form a rounded shape due to surface tension. The exact temperature and time will be optimized for the specific photoresist and feature size. Once the desired condition is optimized for each feature size. It can be set for production as the entire process is very repeatable.

Feature Size Variation: For features on the order of micrometers, maintaining a size variation of a couple of micrometers is generally achievable with standard photolithography equipment and processes. No additional special processes or equipment are required.

To achieve the desired feature size and variation, appropriate photolithography parameters are selected and a quality mask is used. Accurate feature size and shape is also achieved when the mask is manufactured to have high precision and the photolithography equipment is well-calibrated. Additionally, environmental factors such as temperature and humidity should be controlled to prevent variations in the photoresist behavior.

Overall, with proper process control and equipment calibration, creating round shapes with micrometer-scale features and minimal size variation is not only feasible but also cost-effective for large-scale production.

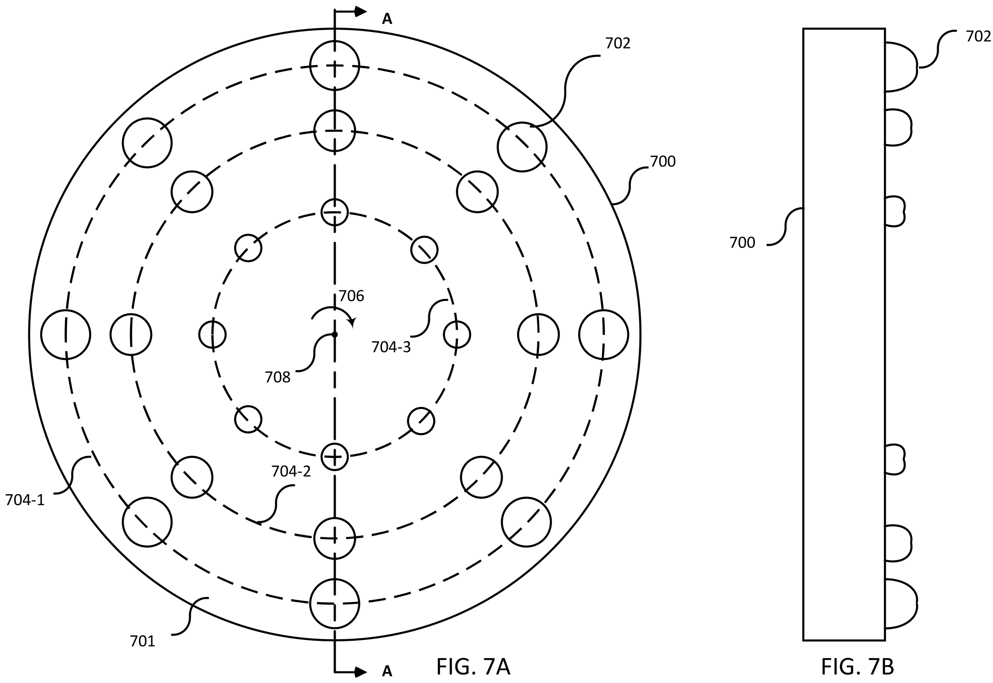

FIGs. 7A and 7B illustrate a top view and a side (cross-section taken along line A-A) view of a rotating carrier 700 with microtargets 702 formed thereon to be utilized for testing and calibration of an OPS such as OPS 208 of FIG. 2. In one embodiment, rotating carrier 700 is a circular glass wafer or substrate that has microtargets 702 formed using any appropriate process, such as process 400 of FIG. 4.

In this example, rotating carrier 700 includes microtargets 702 formed in three concentric rings 704-1 to 704-N on surface 701 of rotating carrier 700. In process 400 of FIG. 4, for example, the location of microtargets is defined by openings formed along at least a portion of a circumference of each of the rings 704-1 to 704-N. Microtargets 702 in each of three rings 704-1 to 704-N has a different size in this example. In other examples of rotating carrier 700, microtargets 702 may have any appropriate size, spacing and orientation to enable testing and calibration of the OPS, e.g., OPS 208 of FIG. 2.

In operation, rotating carrier 700 is placed such that microtargets 702 rotate through a measurement volume of the OPS when rotating carrier 700 rotates around center 708 in direction of arrow 706. When rotated, microtargets 702 on surface 701 of rotating carrier 700 pass through the measurement volume of the OPS and simulate particles passing through the measurement volume. Advantageously, microtargets 702 on any of three rings 704-1 to 704-N may be rotated through the measurement volume of the OPS to test sensitivity to different sized particles.

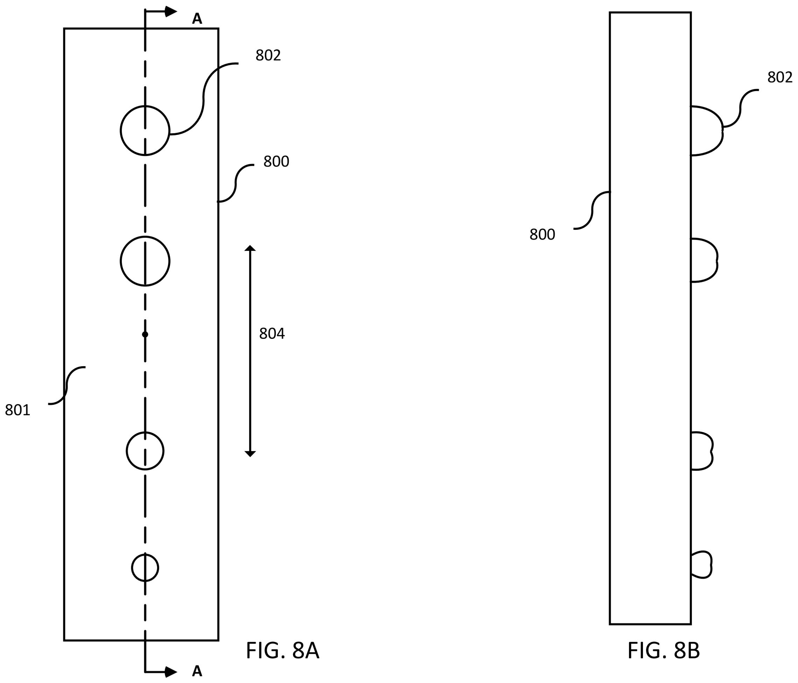

FIGs. 8A and 8B are front view and side view (in cross section along line A-A), respectively, of one embodiment of an oscillating carrier 800 with microtargets 802 formed thereon for testing an OPS, such as OPS 102 of FIG. 1, by oscillating the oscillating carrier 800. Oscillating carrier 800 includes microtargets 802 of varying sizes formed along the length of oscillating carrier 800.

In this embodiment, oscillating carrier 800 oscillates in the direction of arrow 804 to enable microtargets 802 to move through a measurement volume of the OPS, such as OPS 102 of FIG. 1. Microtargets 802, in one embodiment, are formed on surface 801 of oscillating carrier 800 using process 400 of FIG. 4 or other appropriate process.

In operation, oscillating carrier 800 is placed in position to enable one or more of microtargets 802 on surface 801 of oscillating carrier 800 to pass through a measurement volume of an OPS, e.g., OPS 102 of FIG. 1.

In an alternate embodiment of FIG. 4, process 400 omits block 411 (thermal reflow). When thermal reflow is omitted, microtargets 514 (FIG. 5C) can have a relatively flat surface.

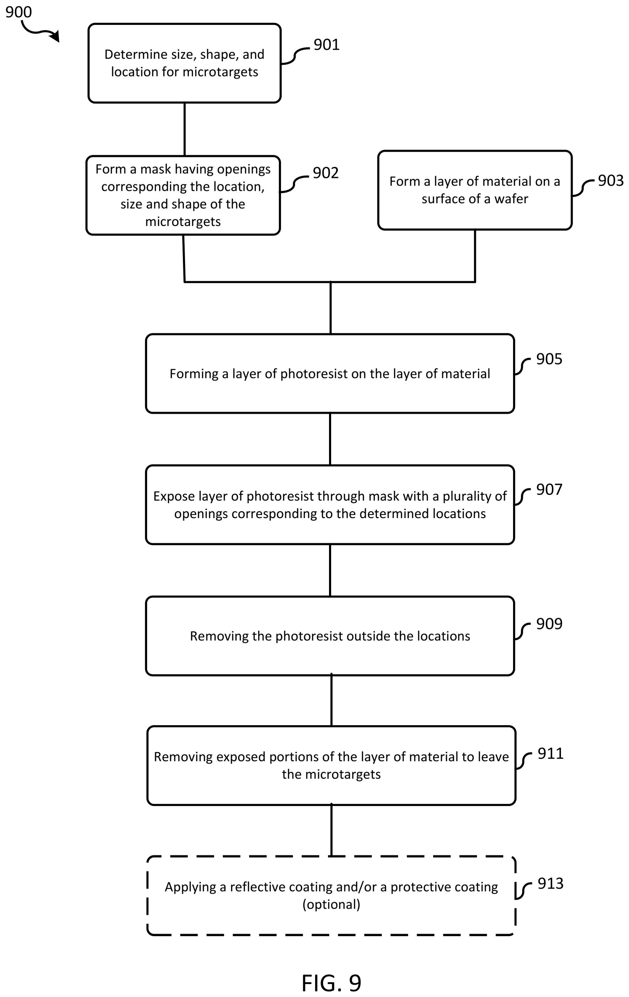

FIG. 9 is a flow chart illustrating another embodiment of a process 900 for fabricating microtargets according to the teachings of the present invention. In this alternative embodiment, the microtargets are fabricated from metal. It is noted that in various embodiments, the microtargets can be formed from a variety of materials including but not limited to epoxy, photoresist (see above with respect to FIG. 4), polymer, metal (described below with respect to FIG. 9), metallic oxide, etc. to have microtargets and substrates with appropriate reflectivity corresponding to a wavelength of a laser of an OPS that is to be tested and/or calibrated. It is noted that the blocks illustrated in the flow chart are exemplary and not intended to limit the order or sequence in which they are performed. The blocks may be rearranged or performed in different sequences, including performing various blocks in parallel, without departing from the scope of the invention. For example, blocks 901 and 902 can be performed in parallel with block 903.

At block 901, process 900 determines the size, shape, curvature, and location of microtargets for testing and/or calibration of an OPS, such as OPS 102 of FIG. 1 or OPS 208 of FIG. 2. For example, the size and shape of microtargets may be selected based on the range of sizes of particles expected to be encountered by the OPS. Further, the location of the microtargets can be determined based on the anticipated speed of particles expected for the OPS. The location of the microtargets may also be chosen to fully test the measurement volume of the OPS. Block 901 results in a template for the layout of the microtargets on the wafer or substrate of the carrier. At block 902, this template is used to create a mask with openings corresponding to the location, size and shape of the microtargets.

At block 903, a layer of material is formed on a surface of a substrate or wafer. For example, this layer of material may comprise an appropriate metal or metallic oxide. In embodiments of the invention, this layer of material is formed by platting or sputtering to replace spin coating of process 400. Additionally, the metal or metallic oxide film in process 900 replaces the layer of photoresist used in process 400.

In process 900, photolithography is still used to define the size and location of the microtargets. At block 905, a layer of photoresist material is formed on the layer of material (metal or metallic oxide). At block 907, this layer of photoresist material is exposed to ultraviolet (UV) light at an appropriate wavelength to develop portions of the layer of photoresist exposed through the mask in a manner similar to that described above with respect to block 407 such that the mask defines the locations in the layer of material (metal or metallic oxide) that will remain and function as the microtargets. At block 909, portions of the layer of photoresist material that does not cover the locations of the microtargets is removed. At block 911, the layer of material (metal or metallic oxide) is etched (dry or wet) through the exposed portions of the layer of photoresist material. This leaves the microtargets at the locations selected at block 901. Finally, the remaining photoresist is removed to produce the substrate or wafer with the metal (or metallic oxide) microtargets formed thereon.

At block 913, process 900 includes an option to add either a reflective coating or a protective coating to the microtargets. When a reflective coating is applied to microtargets, it increases the reflectivity of the microtargets and thus improves the signal level received by the OPS under test. To apply a reflective coating, process 900 may use the same mask used to define the microtargets at block 907 to enable a reflective material to be applied to the microtargets by a sputtering process. It is noted that the reflective coating could be applied to a subset of microtargets so that a portion of the microtargets have increased reflectivity. In this embodiment, a mask is created that only exposes the microtargets in a portion of the wafer to receive the reflective coating. When a protective coating is desired, process 900 forms the protective coating layer on (1) the surface of the wafer or substrate, (2) the microtargets or (3) both the surface of the wafer and the microtargets to prevent water or dust from accumulating or sticking to the wafer and/or microtargets. In one embodiment, the protective coating layer is formed from a hydrophobic material that resists water, e.g., hydrophobic polymers.

It is noted that the processes described above with respect to FIG. 4 and FIG. 9 describe formation of microtargets in a single layer of material. However, it is understood that the processes described above with respect to FIG. 4 and FIG. 9, in other embodiments, may be repeated with different masks at different layers to enable creation of microtargets with different three-dimensional designs or shapes.

Further, in other embodiments, microtargets of different materials are formed on the same wafer or substrate. For example, the process of FIG. 4 may be used to fabricate microtargets from photoresist over a portion of the wafer or substrate using appropriate masking. In this embodiment, the remainder of the substrate may receive microtargets formed from a different material such as a metal or metal oxide using the process of FIG. 9 using a different mask that enables formation of the microtargets over the remainder of the wafer or disk.

Terms of relative position used in this application are defined based on a plane parallel to the conventional plane or working surface of a material (e.g., a layer or a substrate), regardless of orientation. Terms such as "on," "higher," "lower," "over," "top," and "under" are defined with respect to the conventional plane or working surface being on the top surface of a layer or substrate, regardless of orientation. The terms "about" or "substantially" indicate that the value or parameter specified may be somewhat altered, as long as the alteration does not result in nonconformance of the process or structure to the illustrated embodiment. Finally, "exemplary" indicates the description is used as an example, rather than implying that it is an ideal. Although specific embodiments have been illustrated and described herein, it will be appreciated by those of ordinary skill in the art that any arrangement, which is calculated to achieve the same purpose, may be substituted for the specific embodiments shown.

The methods and techniques described here may be implemented in digital electronic circuitry, or with a programmable processor (for example, a special-purpose processor or a general-purpose processor such as a computer) firmware, software, or in combinations of them. Apparatus embodying these techniques may include appropriate input and output devices, a programmable processor, and a storage medium tangibly embodying program instructions for execution by the programmable processor. A process embodying these techniques may be performed by a programmable processor executing a program of instructions to perform desired functions by operating on input data and generating appropriate output. The techniques may advantageously be implemented in one or more programs that are executable on a programmable system including at least one programmable processor coupled to receive data and instructions from, and to transmit data and instructions to, a data storage system, at least one input device, and at least one output device. Generally, a processor will receive instructions and data from a read-only memory and/or a random access memory or other non-transitory computer readable medium. Storage devices suitable for tangibly embodying computer program instructions and data include all forms of non-volatile memory, including by way of example semiconductor memory devices, such as EPROM, EEPROM, and flash memory devices; magnetic disks such as internal hard disks and removable disks; magneto-optical disks; and DVD disks. Any of the foregoing may be supplemented by, or incorporated in, specially-designed application-specific integrated circuits (ASICs) or Field Programmable Gate Arrays (FGPAs).

### EXAMPLE EMBODIMENTS

Although specific embodiments have been illustrated and described herein, it will be appreciated by those of ordinary skill in the art that any arrangement, which is calculated to achieve the same purpose, may be substituted for the specific embodiment shown. This application is intended to cover any adaptations or variations of the present invention. Therefore, it is manifestly intended that this invention be limited only by the claims and the equivalents thereof.

Example 1 includes a method for fabricating microtargets for sensor calibration and testing, the method comprising: determining size, shape, curvature and locations for the microtargets; forming a layer of photoresist on a surface of a wafer; forming a mask having a plurality of openings with size, shape, and locations corresponding to the microtargets; heating the wafer and the layer of photoresist; exposing the layer of photoresist through the mask; removing photoresist in the layer of photoresist that was exposed outside the locations of the microtargets; and heating the wafer with a temperature and duration to solidify the microtargets.

Example 2 includes the method of example 1, and further comprising, after removing the photoresist outside the locations of the microtargets, heating the photoresist to a temperature above the glass transition temperature of the photoresist so that the photoresist forms a rounded shape at the locations of the microtargets.

Example 3 includes the method of example 2, exposing the photoresist to UV light to further control the curvature of the microtargets.

Example 4 includes the method of any of examples 1 to 3, wherein forming a layer of photoresist comprises forming a layer of photoresist by spin coating SU-8 photoresist onto the surface of the wafer.

Example 5 includes the method of any of examples 1 to 4, wherein forming the mask comprises forming a mask to include a plurality of openings formed along at least a portion of a circumference of a ring on a surface of the wafer, the ring concentric with the wafer.

Example 6 includes the method of any of examples 1 to 5, wherein forming the mask further comprises forming openings on the circumference of plurality of concentric rings on the surface of the wafer to correspond to the determined size, shape and location of the microtargets.

Example 7 includes the method of any of examples 1 to 6, wherein exposing the layer of photoresist comprises exposing the layer of photoresist with ultraviolet (UV) light with a wavelength selected to develop exposed portions of the layer of photoresist.

Example 8 includes the method of any of examples 1 to 7, wherein removing the photoresist in the layer of photoresist comprises applying a developer to the layer of photoresist.

Example 9 includes the method any of examples 1 to 8, further comprising forming a reflective and/or protective coating on the microtargets.

Example 10 includes the method of any of examples 1 to 9, wherein forming the layer of photoresist comprises forming the layer of photoresist with differing thicknesses of photoresist over the surface of the wafer to enable formation of microtargets of differing heights from the surface of the wafer.

Example 11 includes a method for fabricating microtargets for sensor calibration and testing, the method comprising: determining size, shape, curvature and locations for the microtargets; forming a mask having a plurality of openings in locations corresponding to the locations, size and shape of the microtargets; spin coating a layer of photoresist on a surface of a circular wafer; heating the circular wafer and the layer of photoresist; exposing the layer of photoresist through a mask; removing photoresist in the layer of photoresist that is outside the locations of the microtargets; heating the photoresist to a temperature above the glass transition temperature of the photoresist so that the photoresist forms a rounded shape at the locations of the microtargets; and heating the wafer with a temperature and duration to solidify the microtargets.

Example 12 includes the method of example 11, wherein spin coating a layer of photoresist comprises spin coating SU-8 photoresist onto the surface of the circular wafer.

Example 13 includes the method any of examples 11 to 12, wherein forming the mask comprises forming a mask to include a plurality of openings formed along at least a portion of a circumference of a ring on a surface of the circular wafer, the ring concentric with the circular wafer.

Example 14 includes the method of any of examples 11 to 13, wherein forming the mask further comprises forming openings on a circumference of a plurality of concentric rings on the surface of the circular wafer to correspond to the determined size, shape and location of the microtargets.

Example 15 includes the method any of examples 11 to 14, further comprising forming a reflective and/or protective coating on the microtargets.

Example 16. includes the method any of examples 11 to 15, wherein spin coating the layer of photoresist comprises spin coating the layer of photoresist with differing thicknesses of photoresist over the surface of the wafer to enable formation of microtargets of differing heights from the surface of the wafer.

Example 17 includes a method for fabricating microtargets for sensor calibration and testing. The method includes: determining size, shape, and locations for the microtargets; forming a mask with openings corresponding to the size, shape and location of the microtargets; forming a layer of material on a surface of a wafer; forming a layer of photoresist on the layer of material; exposing the layer of photoresist through the mask; removing photoresist in the layer of photoresist that is outside the locations of the microtargets; removing exposed portions of the layer of material to leave the microtargets in the determined locations; and removing the remaining portions of the layer of photoresist.

Example 18 includes the method of example 17, wherein forming a layer of material comprises plating or sputtering a metal or metallic oxide film on the surface of the wafer.

Example 19. includes the method of any of examples 17 to 18, wherein removing exposed portions of the layer of material comprises removing the exposed portions of the layer of material with a wet or dry etch.

Example 20 includes the method of any of examples 17 to 19, wherein forming the mask comprises forming the mask to include a plurality of openings formed along at least a portion of a circumference of a ring on a surface of the wafer, the ring concentric with the wafer.

## Claims

1. A method for fabricating microtargets for sensor calibration and testing, the method comprising:
determining size, shape, curvature and locations for the microtargets (401);
forming a layer of photoresist on a surface of a wafer (403);
forming a mask having a plurality of openings with size, shape, and locations corresponding to the microtargets (402);
heating the wafer and the layer of photoresist (405);
exposing the layer of photoresist through the mask (407);
removing photoresist in the layer of photoresist that was exposed outside the locations of the microtargets (409); and
heating the wafer with a temperature and duration to solidify the microtargets (413).

2. The method of claim 1, and further comprising, after removing the photoresist outside the locations of the microtargets, heating the photoresist to a temperature above the glass transition temperature of the photoresist so that the photoresist forms a rounded shape at the locations of the microtargets (411).

3. The method of claim 2, exposing the photoresist to UV light to further control the curvature of the microtargets.

4. The method of claim 1, wherein forming a layer of photoresist comprises forming a layer of photoresist by spin coating SU-8 photoresist onto the surface of the wafer.

5. The method of claim 1, wherein forming the mask comprises forming a mask to include a plurality of openings formed along at least a portion of a circumference of a ring on a surface of the wafer, the ring concentric with the wafer.

6. The method of claim 1, wherein forming the mask further comprises forming openings on the circumference of plurality of concentric rings on the surface of the wafer to correspond to the determined size, shape and location of the microtargets.

7. The method of claim 1, wherein exposing the layer of photoresist comprises exposing the layer of photoresist with ultraviolet (UV) light with a wavelength selected to develop exposed portions of the layer of photoresist.

8. The method of claim 1, wherein removing the photoresist in the layer of photoresist comprises applying a developer to the layer of photoresist.

9. The method of claim 1, further comprising forming a reflective and/or protective coating on the microtargets (415).

10. The method of claim 1, wherein forming the layer of photoresist comprises forming the layer of photoresist with differing thicknesses of photoresist over the surface of the wafer to enable formation of microtargets of differing heights from the surface of the wafer.
